## Europäisches Patentamt
## European Patent Office
## Office européen des brevets

(19)

(11) Numéro de publication : **0 148 898**
B1

(12)

# FASCICULE DE BREVET EUROPÉEN

(45) Date de publication du fascicule du brevet :
28.09.88

(51) Int. Cl.⁴ : **H 01 J 37/32**, C 23 C  8/36, C 23 F  1/00

(21) Numéro de dépôt : 84902592.9

(22) Date de dépôt : 05.07.84

(86) Numéro de dépôt international :
PCT/FR 84/00167

(87) Numéro de publication internationale :
WO/8500466 (31.01.85 Gazette 85/03)

(54) APPAREIL DE TRAITEMENT PAR PLASMA DE SUBSTRATS EN FORME DE PLAQUETTES.

(30) Priorité : 05.07.83 FR 8311183

(43) Date de publication de la demande :
24.07.85 Bulletin 85/30

(45) Mention de la délivrance du brevet :
28.09.88 Bulletin 88/39

(84) Etats contractants désignés :
AT BE CH DE FR GB LI LU NL SE

(56) Documents cités :
EP-A- 0 090 067
DE-A- 2 703 659
GB-A- 2 014 500
GB-A- 2 026 369
Patents Abstracts of Japan, Vol. 7, No. 171 (C-178, 1316), 28 July 1983
Patents Abstracts of Japan, Vol. 7, No. 53 (C-154, 1198), 3 March 1983

(73) Titulaire : **NEXTRAL**
**Chemin des Prés Locazirst 4 Extension Batiment B**
**F-38240 Meylan (FR)**

(72) Inventeur : **PARRENS, Pierre**
**Tour Mont Blanc 15 boulevard du Maréchal Leclerc**
**F-38000 Grenoble (FR)**

(74) Mandataire : **Casalonga, Axel et al**
**BUREAU D.A. CASALONGA OFFICE JOSSE & PETIT**
**Morassistrasse 8**
**D-8000 München 5 (DE)**

## Description

La présente invention concerne un appareil de traitement par plasma de substrats en forme de plaquettes et notamment un appareil de gravure.

Dans l'état de la technique actuel, on connaît une machine de traitement par plasma qui comprend une cathode en forme de colonne à la périphérie de laquelle peuvent être disposées les plaquettes à traiter et, autour de cette colonne et à distance, une enceinte cylindrique formant anode et délimitant l'enceinte de réaction. Dans cette machine, le gaz de réaction est admis par l'intermédiaire de conduits qui s'étendent dans l'espace séparant la colonne centrale formant cathode de l'enveloppe cylindrique et il est évacué par l'une des extrémités de cet espace. Du fait de cette structure, l'écoulement à l'intérieur de l'enceinte du gaz de réaction n'est pas uniforme pour toutes les plaques et il s'ensuit, pour certaines applications, une homogénéité insuffisante du traitement de chaque plaque et une homogénéité insuffisante du traitement des plaques les unes par rapport aux autres. De plus, le chargement et le déchargement des plaquettes sur la colonne formant cathode sont particulièrement compliqués du fait que les plaquettes doivent être chargées et déchargées par rangées verticales.

On connaît également une machine de traitement par plasma qui comprend une couronne formant cathode sur laquelle peuvent être disposées les plaquettes à traiter. L'injection du gaz de réaction est effectuée à la périphérie de la couronne tandis que le pompage est effectué au centre de cette couronne. Cette machine présente l'inconvénient d'occuper un grand volume par rapport au nombre de plaquettes qui sont susceptibles d'être traitées et, compte tenu du sens de circulation du gaz de réaction, les plaquettes présentent une homogénéité de traitement insuffisante.

En outre, dans la première machine comme dans la seconde, le plasma s'allume sur toute la surface des plaquettes mais également sur toute la surface de la cathode. Il s'ensuit une forte consommation d'énergie électrique.

On connaît également, par le brevet GB-A-2 014 500, une machine de traitement par plasma qui comprend une multiplicité de porte-substrats qui sont posés sur une table ainsi qu'un plateau également posé sur cette table et présentant une multiplicité de passages traversant dans lesquels s'étendent les porte-substrats, des interstices annulaires étant ménagés entre ce plateau et les porte-substrats. Du fait de cette disposition, il n'existe aucun écoulement de gaz dans ces interstices annulaires et le gaz s'écoule sur le plateau pour être évacué à sa périphérie. Dans cette machine également, il s'ensuit une inhomogénéité de traitement des substrats.

On connaît également le brevet EP-A-0 090 067 qui, n'ayant été publié que postérieurement à la date de dépôt de la présente demande, doit être considéré comme compris dans l'état de la technique en vertu des dispositions de l'article 54(3) de la Convention sur le Brevet Européen mais ne doit pas être pris en considération pour l'appréciation de l'activité inventive. On peut observer notamment que ce document décrit une machine de traitement par plasma de substrats en forme de plaquettes dans laquelle il est prévu une multiplicité de porte-substrats qui ne sont pas reliées à la source de tension alternative, la cathode étant constituée par un plateau dans lequel sont prévus des passages transversant dans lesquels sont disposés les porte-substrats et le gaz de réaction étant évacué à la périphérie du plateau.

La présente invention a notamment pour but de remédier aux inconvénients de l'état de la technique et propose un appareil de traitement par plasma qui permet une très bonne directivité, une très bonne sélectivité et une très bonne homogénéité du traitement de chacune des plaquettes et des plaquettes les unes par rapport aux autres.

L'appareil de traitement par plasma de substrats en forme de plaquettes de l'invention comprend une enceinte de réaction présentant des moyens d'amenée et des moyens d'évacuation pour un gaz de réaction, au moins une première électrode formant anode formée dans ladite enceinte et adaptée pour être reliée à un potentiel de référence et, placée dans ladite enceinte, une multiplicité de secondes électrodes formant cathodes isolées électriquement de ladite première électrode, adaptées pour être reliées à une source d'énergie électrique alternative et présentant respectivement une surface de réception d'au moins une plaquette située du côté de ladite première électrode, de telle sorte qu'un plasma peut être formé entre ladite première électrode et lesdites secondes électrodes en vue de traiter les plaquettes que les deuxièmes électrodes portent, ainsi qu'au moins un plateau présentant une multiplicité de passages transversants formés de manière à correspondre respectivement à au moins une partie desdites secondes électrodes et adaptés pour que les parois de ces passages s'étendent respectivement à la périphérie et à distance des parois périphériques des secondes électrodes correspondantes.

Conformément à la présente invention les espaces ménagés entre les parois desdits passages traversants dudit plateau et les parois périphériques desdites secondes électrodes forment des passages d'écoulement pour le gaz de réaction, la face supérieure dudit plateau s'étendant sensiblement au même niveau que les faces supérieures desdites secondes électrodes qu'il entoure.

Conformément à la présente invention, ledit plateau est de préférence isolé électriquement desdites secondes électrodes.

Conformément à la présente invention, ledit plateau est de préférence audit potentiel de référence.

Selon la présente invention, ledit plateau, avec les surfaces de réception desdites secondes électrodes, de préférence divisent ladite enceinte de réaction en deux chambres communiquant par lesdits espaces d'écoulement.

Dans une variante selon la présente invention, lesdites cathodes sont munies de canaux intérieurs dans lesquels peut circuler un fluide de refroidissement.

Selon une structure particulière de l'invention, les extrémités desdites secondes électrodes opposées à leur surface de réception sont reliées entre elles par un plateau.

Dans une variante, lesdites secondes électrodes sont formées en saillie, sur un plateau qui présente une multiplicité de canaux transversants répartis autour desdites secondes électrodes en saillie en vue de l'écoulement des gaz au travers de ce plateau. La partie inférieure dudit plateau est de préférence entourée à distance par un écran diffuseur qui porte des écrans cylindriques s'étendant à l'intérieur desdits canaux transversants dudit plateau, à distance de leurs parois. Par ailleurs, ledit plateau portant lesdites secondes électrodes peut être muni d'au moins un canal intérieur dans lequel peut circuler un fluide de refroidissement.

Conformément à la présente invention, des écrans isolés électriquement desdites secondes électrodes peuvent avantageusement être prévus autour de ces dernières dans leur partie s'étendant en dessous de leur surface de réception des plaquettes. De même, des écrans isolés électriquement desdites secondes électrodes peuvent être prévus autour du plateau portant ces secondes électrodes. Lesdits écrans sont en outre de préférence audit potentiel de référence.

Ladite première électrode peut être formée, conformément à une variante d'exécution de l'invention, par un plateau s'étendant en face et à distance des surfaces de réception desdites secondes électrodes, lesdits moyens d'amenée de gaz de réaction comprenant au moins une chambre formée à l'intérieur de cette première électrode et des orifices de communication entre cette chambre inférieure et l'intérieur de ladite enceinte de réaction qui sont situés en face du milieu de chacune desdites électrodes.

Dans une variante particulièrement intéressante de l'invention, ledit plateau présentant une multiplicité de passages transversants est amovible et est muni de moyens pour maintenir respectivement, dans lesdits passages et à distance de leur paroi, des plaquettes, ce plateau étant adapté pour être disposé ou monté dans ladite enceinte de réaction de telle sorte que les plaquettes qu'il porte viennent en appui sur les surfaces de réception de plaquettes desdites secondes électrodes correspondantes. Lesdits moyens de maintien des plaquettes dans lesdits passages transversants dudit plateau amovible sont de préférence formés par des ergots formant supports pour les plaquettes et maintenant ces plaquettes à distance des parois desdits passages transversants. En outre, lesdits moyens pour porter et maintenir les plaquettes dans les passages transversants dudit plateau amovible sont de préférence en un matériau isolant.

La présente invention sera mieux comprise à l'étude d'appareils de traitement par plasma de substrats en forme de plaquettes particuliers décrits à titre d'exemples non limitatifs et illustrés par le dessin sur lequel :

— la figure 1 représente une coupe axiale en élévations selon I-I de la figure 2 d'un premier appareil de traitement, cette coupe en montrant une vue schématique ;

— la figure 2 représente une coupe selon II-II de l'appareil de traitement représenté schématiquement sur la figure 1 ;

— la figure 3 représente une coupe agrandie partielle selon III-III de la figure 2 ;

— la figure 4 représente une vue agrandie partielle de la coupe représentée sur la figure 1 ;

— la figure 5 représente une vue de dessus de la partie inférieure, plateau enlevé, d'un second appareil de traitement ;

— et la figure 6 représente une coupe selon VI-VI de l'appareil de traitement représenté sur la figure 5, plateau monté.

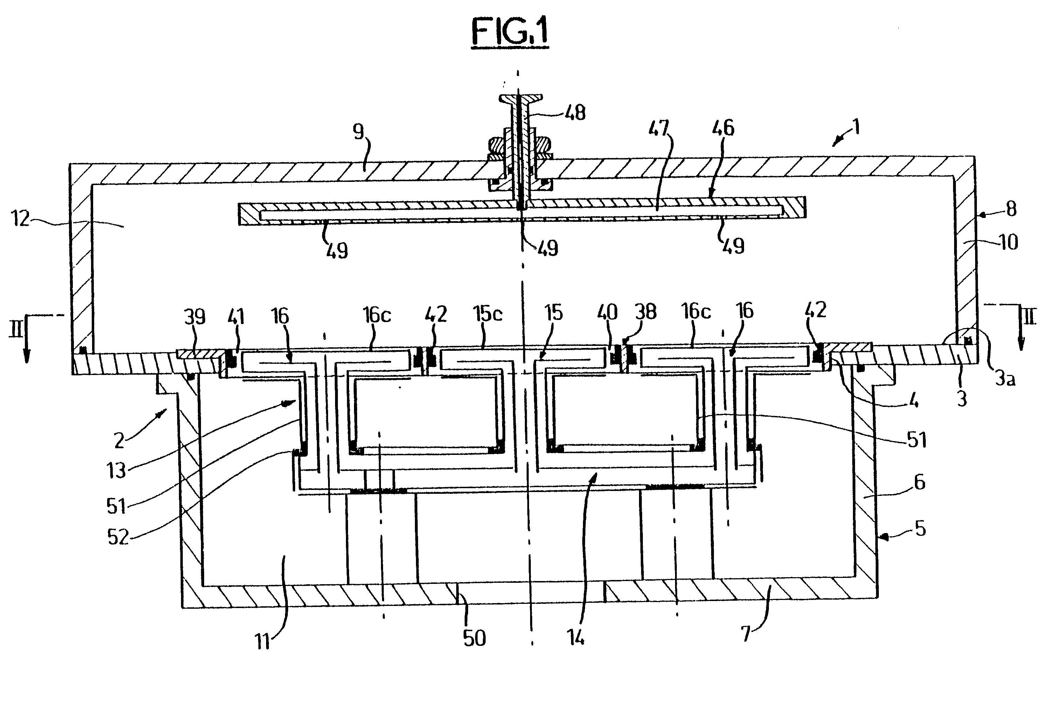

Comme on peut le voir en particulier sur la figure 1, l'appareil de traitement par plasma repéré d'une manière générale par la référence 1 comprend une enceinte de réaction repérée d'une manière générale par la référence 2 et reliée à la masse.

Cette enceinte de réaction 2 comprend une couronne circulaire horizontale 3 au centre de laquelle est ménagée une ouverture circulaire 4, une enveloppe 5 en forme de cuvette qui présente une paroi cylindrique 6 dont l'extrémité est fixée sur la face inférieure de la couronne 3 et un fond 7 horizontal qui se trouve à distance de la couronne 3, ainsi qu'une enveloppe 8 en face de la cloche dont le fond horizontal 9 est à distance du plateau 3 et dont la paroi cylindrique 10 prend appui sur le bord périphérique de la face supérieure 3a de la couronne 3, cette enveloppe 8 étant amovible pour donner accès à l'intérieur de l'enceinte 2 et pouvant être fixée dans la position représentée sur la couronne 3 par des moyens connus non représentés.

Il en résulte que l'enveloppe 5 délimite une chambre inférieure 11 et que l'enveloppe 8 délimite une chambre supérieure 12.

A l'intérieur de l'enceinte de réaction 2 est prévu un ensemble d'électrodes formant cathodes repéré d'une manière générale par la référence 13 qui est agencé de la manière suivante.

Cet ensemble d'électrodes 13 comprend un plateau 14 qui s'étend horizontalement à l'intérieur de la chambre inférieure 11 et qui est porté par la paroi 7 de l'enveloppe 5 comme on le verra plus loin. L'ensemble d'électrodes 13 comprend également une électrode centrale 15 ainsi que six électrodes 16 disposées à la périphérie de l'électrode centrale 15, ces électrodes 15 et 16 s'étendant vers le haut à partir du plateau 14.

L'électrode centrale 15 et les six électrodes 16 sont construites de la même manière. Elles comprennent respectivement à leur partie supérieure une partie cylindrique en forme de disque 15a, 16a et une partie cylindrique 15b, 16b reliant le disque 15a, 16a au plateau 14 et de diamètre inférieur au disque 15a, 16a. Les disques 15a, 16a présentent une face supérieure 15c, 16c qui sont dans un même plan et qui s'étendent sensiblement selon le plan de la face supérieure 3a de la couronne 3. De plus, les disques 15a et 16a sont disposés sensiblement à égale distance les uns des autres et les disques 16a des électrodes périphériques 16 sont à distance de la paroi de la couronne 3 formant l'ouverture 4, de telle sorte qu'entre les électrodes 15 et 16 et la couronne 3 sont ménagés des espaces de communication entre la chambre supérieure 12 et la chambre inférieure 11.

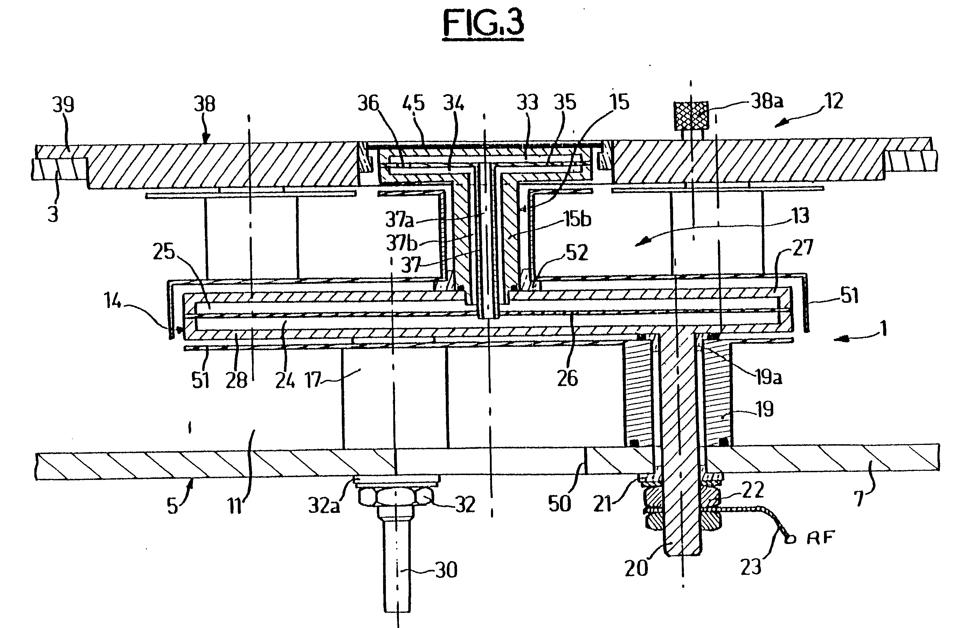

L'ensemble d'électrodes 13 est en appui sur trois pieds 17, 18 et 19 qui s'étendent entre le plateau 14 et la paroi 7 de l'enveloppe 5 et qui sont de forme cylindrique, l'extrémité supérieure de ces pieds étant isolée électriquement du plateau 14 par l'intermédiaire de bagues en un matériau isolant. On voit par exemple, sur la figure 3, que la bague 19 est isolée électriquement du plateau 14 grâce à une bague 19a.

Comme on peut le voir sur la figure 3, le plateau 14 présente un doigt 20 qui s'étend vers le bas au travers du pied 19 et au travers de la paroi 7 de l'enveloppe 5, ce doigt 20 étant isolé électriquement du pied 19 par l'intermédiaire de la bague 19a et isolé électriquement de la paroi 7 de l'enveloppe 5 par l'intermédiaire d'une bague isolante 21. Un écrou 22 vissé sur l'extrémité du doigt 20 et prenant appui sur la bague 21 permet de fixer le plateau à la paroi 7 en comprimant le pied 19. L'extrémité du doigt 20 porte également l'extrémité d'un fil électrique 23 qui permet de relier l'ensemble d'électrodes 13 à une source d'énergie électrique alternative non représentée.

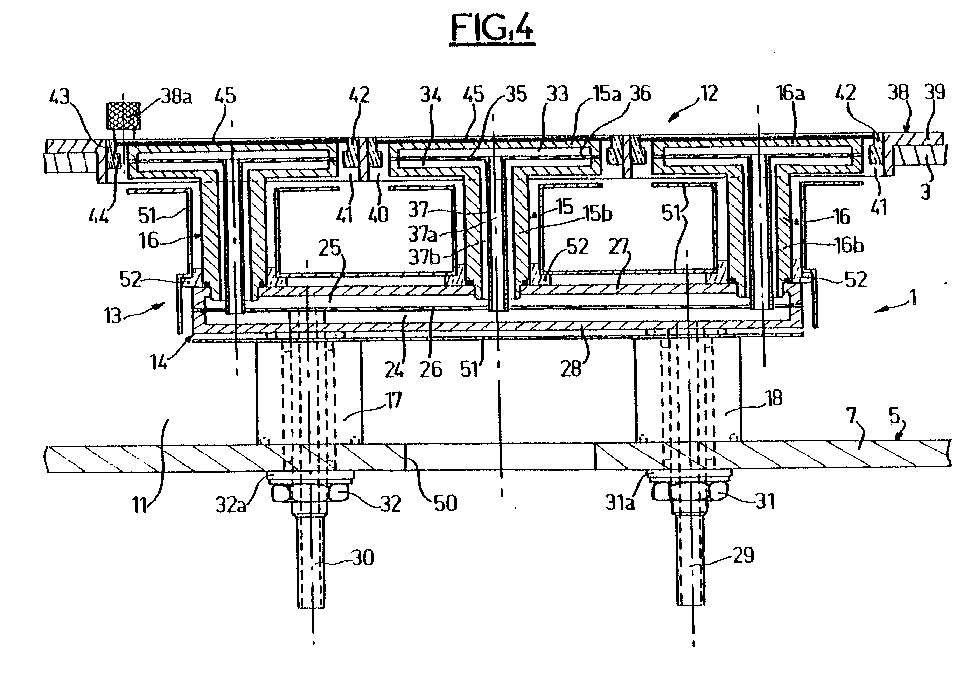

Comme il apparaît notamment sur la figure 3 et sur la figure 4, le plateau 14 comprend deux chambres 24 et 25 qui sont séparées par une paroi horizontale 26, le plateau 14 présentant une paroi supérieure 27 et une paroi inférieure 28 qui sont à distance de la paroi intermédiaire 26. En vue de relier respectivement les chambres 24 et 25 à un circuit de refroidissement extérieur à l'appareil 1 et non représenté, on voit qu'on a prévu un conduit 29 qui s'étend au travers du pied 18 et au travers de la paroi 7 de l'enveloppe 5 et qui est fixé à la paroi 28 du plateau 14, ainsi qu'un conduit 30 qui s'étend au travers du pied 17, au travers de la paroi 7 de l'enveloppe 5 et au travers de la chambre 24 du plateau 14 et qui est fixé à la paroi intermédiaire 26.

L'ensemble d'électrodes 13 est en outre maintenu et fixé grâce à des écrous 31 et 32 qui sont montés sur l'extrémité des conduits 29 et 30, les conduits 29 et 30 étant isolés électriquement du fond 7 de l'enveloppe 5 de la même manière que le doigt 20 grâce à des bagues isolantes 31a et 32a.

L'électrode centrale 15 et les six électrodes 16 qui sont disposées à sa périphérie présentent des canaux intérieurs dont les extrémités sont respectivement reliées aux chambres 24 et 25 ménagées dans le plateau 14. Le disque 15a de l'électrode 15 comprend deux chambres 33 et 34 qui sont séparées par une cloison horizontale 35 dans laquelle sont ménagés différents orifices de communication 36, les chambres 33 et 34 étant respectivement en communication avec les chambres 24 et 25 par l'intermédiaire de deux passages concentriques 37a et 37b ménagés par la partie cylindrique 15b de l'électrode 15 et séparés par un conduit 37 dont les extrémités sont respectivement fixées à la cloison 35 et à la cloison 26. Chacune des électrodes périphériques 16 est structurée de la même manière de telle sorte que les canaux intérieurs des électrodes 15 et 16 sont branchés en parallèle sur les chambres 24 et 25 en vue de faire circuler en parallèle un fluide de refroidissement par exemple admis par le conduit 29 et évacué par le conduit 30.

L'appareil 1 comprend également un plateau amovible 38 de forme circulaire qui est engagé dans l'ouverture 4 de la couronne 3 et qui présente un rebord 39 à sa périphérie qui est en appui sur la face supérieure 3a de la couronne 3 de telle sorte qu'il est relié à la masse. Ce plateau amovible 38 présente un passage traversant central 40 ainsi que six passages traversants 41 dans lesquels respectivement s'étendent les électrodes 15 et 16, ces passages 40 et 41 ayant un diamètre supérieur au diamètre des disques 15a et 16a des électrodes 15 et 16 de manière à ménager entre ces électrodes et la paroi des passages 40 et 41 des espaces annulaires. La face supérieure du plateau amovible 38 s'étend sensiblement au même niveau que les faces supérieures 15a et 16a des électrodes 15 et 16.

Dans les passages 40 et 41 sont prévus des ergots 42 qui sont au nombre de quatre dans chaque passage, ces ergots 42 présentant respectivement une branche 43 qui s'étend vers le haut et une branche inférieure 44 qui s'étend radialement vers l'intérieur et qui forme un épaulement. Les ergots 40 sont formés dans l'espace séparant la paroi latérale des disques 15a et 16a des électrodes 15 et 16 et la paroi intérieure des passages 40 et 41 et sont en un matériau isolant électriquement.

En outre, le plateau 38 est muni à sa partie supérieure de deux doigts 38a qui permettent sa préhension.

En vue de charger ou de décharger l'appareil de traitement 1, on peut effectuer les opérations suivantes. Le plateau amovible 38 étant disposé à l'extérieur de l'enceinte de traitement 2, on dispose dans chacun de ses passages 40 et 41 une plaquette à traiter 45 qui prend appui sur les écoulements 44 des ergots 42. L'enveloppe 8 en forme de cloche étant démontée ou ouverte, on place le plateau amovible 38 de telle sorte qu'il s'engage à l'intérieur de l'ouverture 4 de la couronne 3 et autour des électrodes 15 et 16. Ce faisant, les plaquettes 45 viennent en appui sur la face supérieure 15c et 16c des électrodes 15 et 16 en s'éloignant des épaulements 44 des différents ergots 42, les plaquettes 45 restant centrées par rapport aux électrodes 15 et 16 grâce aux branches verticales 43 des ergots 42, un espace annulaire demeurant donc entre la paroi des passages 40 et 41 du plateau 38 et le bord périphérique des plaquettes 45.

En vue de décharger l'ensemble des plaquettes 45 disposées dans l'appareil 1, il suffit de retirer le plateau amovible 38, les plaquettes 45 venant de nouveau en appui sur les épaulements 44 des ergots 42.

Comme on peut le voir sur la figure 1, l'appareil de traitement 1 comprend une anode 46 reliée à la masse qui se présente sous la forme d'un plateau porté par la paroi 9 de l'enveloppe 8. Ce plateau 46 s'étend dans la partie supérieure de la chambre supérieure 12 et couvre sensiblement la zone des électrodes 15 et 16, ce plateau 46 étant fixé à la paroi 9 de l'enveloppe supérieure 8. Ce plateau formant anode 46 comprend une chambre intérieure 47 sur laquelle est branchée un conduit central 48 qui traverse la paroi 9 de l'enveloppe 8 et sur lequel peut être branché un conduit d'amenée de gaz de réaction, le plateau 46 présentant en outre des orifices de communication 49 qui permettent de mettre en communication la chambre 47 avec l'intérieur de l'enceinte de réaction 2, ces orifices 49 étant formés respectivement en face du milieu de chacune des électrodes 15 et 16.

La paroi 7 de l'enveloppe 5 présente une grande ouverture 50 qui permet de mettre en communication l'intérieur de l'enceinte 2 avec une pompe non représentée sur les figures.

Lorsque l'appareil 1 fonctionne, c'est-à-dire lorsque l'ensemble d'électrodes 13 est soumis à une source d'énergie alternative au travers du fil électrique 23 et du doigt 20 et qu'un gaz de réaction est admis par le conduit 48, et aspiré par l'ouverture 50 grâce à une pompe, l'enceinte de réaction étant fermée, le gaz de réaction s'écoule au travers du conduit 48, de la chambre intérieure 47 de l'électrode 46, est admis dans la chambre supérieure 12 par les orifices de communication 49, au-dessus de chacune des électrodes 15 et 16, diffuse dans la chambre 12, s'écoule au travers des espaces annulaires ménagés entre le bord des plaquettes 45 et les parois latérales des parties 15a et 16a des électrodes 15 et 16 et les parois des passages traversants 40 et 41 du plateau amovible 38 puis traverse la chambre inférieure 11 pour être évacué par l'ouverture 50 de la paroi 7 de l'enveloppe 5. Comme le plateau amovible 38 est relié à la masse, il s'ensuit que le plasma ne s'allume qu'au-dessus des plaquettes 45 portées par les électrodes 15 et 16 uniquement.

En outre, en vue d'éviter que le plasma ne s'allume dans la chambre inférieure 11, on a prévu autour du plateau 14, autour des parties cylindriques 15b et 16b des électrodes 15 et 16 et en dessous des disques 15a et 15b de ces électrodes des parois 51 formant écran qui sont à faible distance du plateau 14 et des électrodes 15 et 16 et isolés électriquement de ces derniers grâce à des bagues 52 en un matériau isolant.

Il ressort de la description qui précède que les plaquettes 45 disposées respectivement sur les électrodes 15 et 16 sont sensiblement dans les mêmes conditions de traitement. D'une part elles sont chacune traitées par un flux de gaz particulier qui diffuse à partir de chacun des orifices 49 situés en face du milieu de chacune des électrodes 15 et 16 et s'écoule à leur périphérie, le plasma n'étant formé que dans la zone nécessaire au traitement des plaquettes 45 de telle sorte que la quantité d'énergie électrique utile est limitée. D'autre part, comme les électrodes 15 et 16 sont respectivement refroidies par l'intermédiaire de canaux intérieurs branchés en parallèle sur un circuit de refroidissement, elles sont toutes maintenues sensiblement à la même température.

On peut noter également que par réglage de la position verticale du plateau amovible 38 qui est relié à la masse et qui entoure les électrodes 15 et 16 ou par réglage de la position verticale du plateau 46 formant anode par l'intermédiaire duquel le gaz de réaction est admis, il est possible d'agir sur le plasma formé.

En outre, grâce au plateau amovible 38, il est possible de charger et de décharger l'ensemble des plaquettes 45 en une seule opération de telle sorte que la cadence de traitement à l'aide de l'appareil de traitement 1 peut être importante, par exemple en disposant de plusieurs plateaux amovibles identiques.

Un autre avantage de l'appareil de traitement 1 réside dans le fait que, comme le plasma se forme entre l'anode constituée par le plateau 46, on peut refroidir ce plateau 46 et en conséquence il n'est pas nécessaire de refroidir les parois formant l'enceinte de traitement 2.

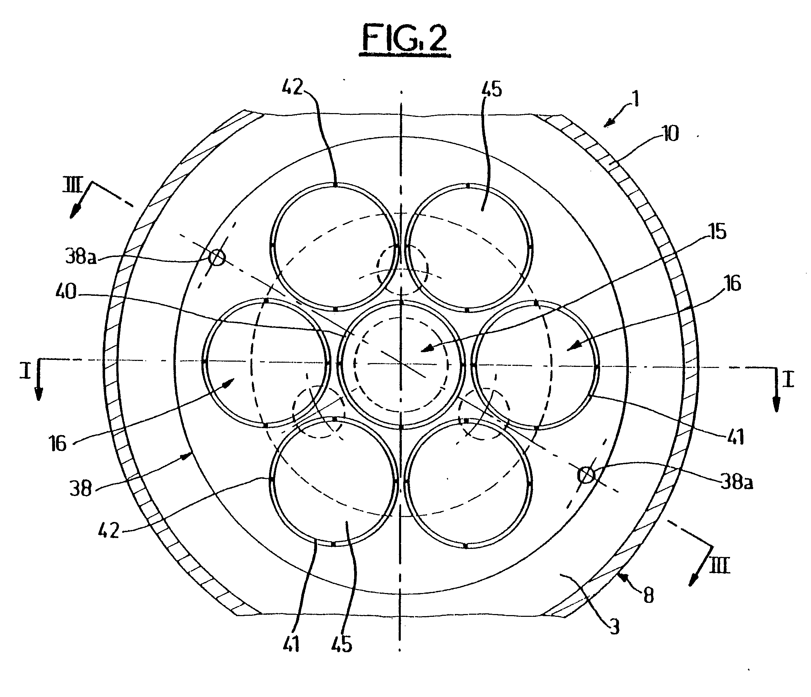

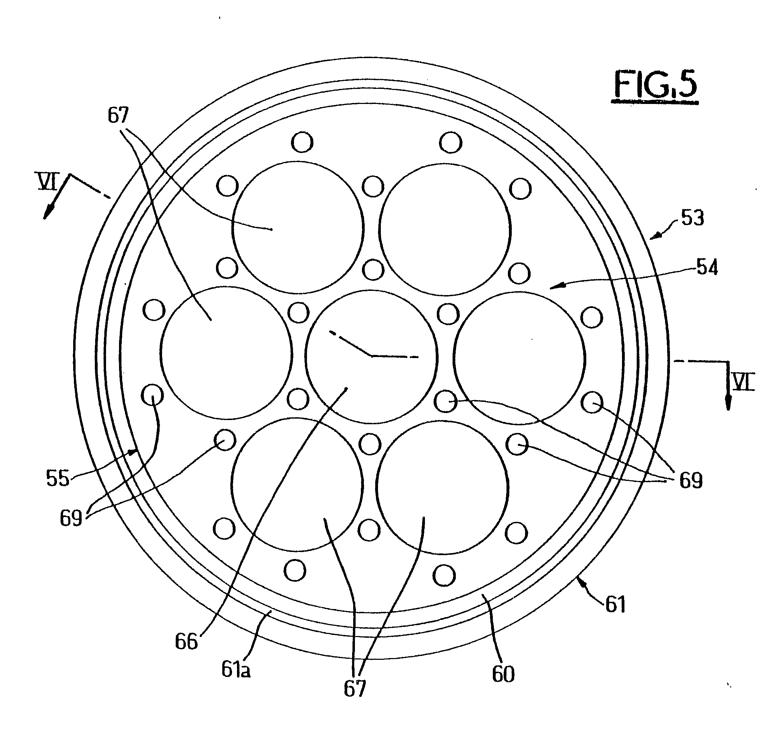

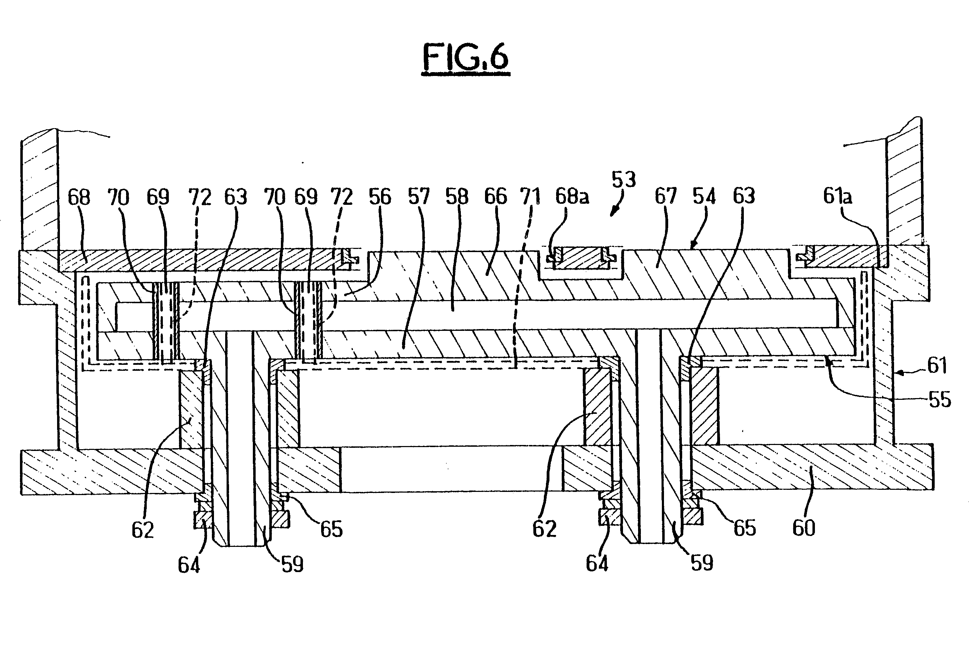

En se reportant aux figures 5 et 6, on va maintenant décrire un appareil de traitement par plasma repéré d'une manière générale par la référence 53 qui fonctionne et peut être utilisé de la même manière que l'appareil de traitement 1 représenté sur les figures 1 à 4 et décrit ci-dessus et qui s'en différencie essentiellement par la structure de son ensemble d'électrodes repéré d'une manière générale par la référence 54 qui correspond à l'ensemble d'électrodes 13 de l'appareil de traitement 1.

L'ensemble d'électrodes 54 de l'appareil de traitement 53 comprend un plateau horizontal 55 en deux parties 56 et 57 en forme de disques qui délimitent entre elles une chambre 58 et qui sont fixées l'une à l'autre.

La partie inférieure en forme de disque 57 du plateau 55 présente des conduits 59 qui s'étendent vers le bas et qui traversent la paroi inférieure 60 de l'enveloppe 61 de l'appareil de traitement 53. Ces conduits 59 permettent de faire circuler à l'intérieur du plateau 55 un fluide de refroidissement ou de maintien en température du plateau 55, les uns servant à l'année et les autres à l'évacuation du fluide de refroidissement.

Afin de fixer le plateau 55 à l'enveloppe 61, à distance de ses parois intérieures, on a prévu des douilles 62 qui entourent à distance les conduits 59, qui sont en appui sur la paroi 60 de l'enveloppe 61 et sur lesquelles la partie 57 du plateau 55 est en appui par l'intermédiaire de bagues 63 en un matériau isolant. Des écrous 64 sont vissés sur les extrémités des conduits 59, à l'extérieur de la paroi inférieure 60 de l'enveloppe 61 et sont en appui sur la face extérieure de la paroi inférieure 60 par l'intermédiaire de bagues 65 en un matériau isolant. Il s'ensuit que, grâce aux bagues 63 et 65, le plateau 55 de l'ensemble d'électrodes 54 est complètement isolé de l'enceinte 61.

Afin d'alimenter le plateau 55 en énergie électrique, on peut avantageusement prévoir un doigt équivalent au doigt 20 prévu dans l'appareil de traitement représenté sur les figures 1 à 4, également isolé électriquement de l'enveloppe 61.

Dans l'exemple représenté, la partie 56 en forme de disque du plateau 55 de l'appareil de traitement 53 présente, en saillie vers le haut, une partie vers le haut, une partie centrale 66 et six parties périphériques 67, qui sont de section circulaire et qui sont régulièrement espacées les unes par rapport aux autres. Les faces supérieures de ces parties 66 et 67, qui sont dans le même plan, constituent des faces de réception pour des substrats ou plaquettes.

Comme on le voit sur la figure 6, l'appareil de traitement 53 comprend un plateau amovible 68 de structure équivalente au plateau amovible 38 de l'appareil de traitement 1 représenté sur les figures 1 à 4. Comme dans l'exemple précédent, ce plateau 68 peut venir à sa périphérie en appui sur un épaulement 61a de l'enveloppe 61 et y est électriquement relié et comprend sept passages traversants correspondant aux parties en saillie 66 et 67 du plateau 55 dans lesquels sont prévus des ergots 68a en un matériau isolant pour le transport et le maintien de plaquettes. En position montée, le plateau amovible 68 s'étend à distance de la face supérieure de la partie en forme de disque 56 du plateau 55 et à distance des parois latérales des parties en saillie 66 et 67 de ce plateau 55 de telle sorte qu'il en est isolé électriquement.

En vue de l'écoulement du gaz de réaction au travers du plateau 55, après qu'il ait traversé les espaces d'écoulement séparant les parties en saillie 66 et 67 du plateau 55 et les parois des passages ménagés dans le plateau amovible 68, on voit en particulier sur la figure 5 qu'on a prévu une multiplicité de canaux 69 qui traversent le plateau 55 dans le sens axial et dont les parois intérieures sont formées par des entretoises cylindriques 70 qui relient les parties en forme de disque 56 et 57 et qui traversent la chambre 58. Dans l'exemple représenté, le plateau 55 comprend six passages 69 répartis autour de chacune des parties en saillie 66 et 67 du plateau 55 et à faible distance de ces parties en saillie. De cette manière, l'écoulement du gaz de réaction peut être assuré régulièrement.

En se reportant à la figure 6, on voit qu'on a prévu également un écran diffuseur 71 présentant une grande quantité de perforations non représentées sur la figure, cet écran diffuseur 71 s'étendant à distance de la face inférieure du disque 57 du plateau 55 ainsi qu'autour et à distance de la paroi latérale de ce dernier, dans l'espace séparant cette paroi latérale de l'enveloppe 61, et étant relié électriquement à l'enveloppe 61. Cet écran diffuseur 71 pourrait en outre porter des écrans cylindriques 72 s'étendant à l'intérieur des passages 69, à distance de leurs parois intérieures et jusqu'à leurs parties supérieures.

La présente invention ne se limite pas aux exemples ci-dessus décrits. Un grand nombre de variantes sont possibles sans sortir du cadre défini par les revendications annexées.

## Revendications

1. Appareil de traitement par plasma de substrats en forme de plaquettes (45) comprenant une enceinte de réaction (2) présentant des moyens d'amenée (48) et des moyens d'évacuation (50) pour un gaz de réaction, au moins une première électrode formant anode (46) formée dans ladite enceinte et adaptée pour être reliée à un potentiel de référence et, placée dans ladite enceinte, une multiplicité de secondes électrodes formant cathodes isolées électriquement de ladite première électrode, adaptées pour être reliées à une source d'énergie électrique alternative et présentant respectivement une surface de réception d'au moins une plaquette située du côté de ladite première électrode, de telle sorte qu'un plasma peut être formé entre ladite première électrode et lesdites secondes électrodes en vue de traiter les plaquettes que les deuxièmes électrodes portent, ainsi qu'au moins un plateau (38) présentant une multiplicité de passages traversants (40, 41) formés de manière à correspondre respectivement à au moins une partie desdites secondes électrodes (15, 16) et adaptés pour que les parois de ces passages (40, 41) s'étendent respectivement à la périphérie et à distance des parois périphériques des secondes électrodes correspondantes (15, 16) caractérisé par le fait que les espaces ménagés entre les parois desdits passages traversants (40, 41) dudit plateau (38) et des parois périphériques desdites secondes électrodes (15, 16) forment des passages d'écoulement pour le gaz de réaction, la face supérieure dudit plateau (38) s'étendant sensiblement au même niveau que les faces supérieures desdites secondes électrodes qu'il entoure.

2. Appareil de traitement selon la revendication 1, caractérisé par le fait que ledit plateau (38) est isolé électriquement desdites secondes électrodes (15, 16).

3. Appareil de traitement selon l'une des revendications 1 et 2, caractérisé par le fait que ledit plateau (38) est audit potentiel de référence.

4. Appareil de traitement selon l'une quelconque des revendications 1 à 3, caractérisé par le fait que ledit plateau (38), avec les surfaces de réception desdites secondes électrodes (15, 16), divisent ladite enceinte de réaction (2) en deux chambres (11, 12) communiquant par lesdits espaces d'écoulement.

5. Appareil de traitement selon l'une quelconque des revendications précédentes, caractérisé par le fait que lesdites cathodes (15, 16) sont munies de canaux intérieurs dans lesquels peut circuler un fluide de refroidissement.

6. Appareil de traitement selon l'une quelconque des revendications précédentes, caractérisé par le fait que les extrémités desdites secondes électrodes (15, 16) opposées à leur surface de réception (15c, 16c) sont reliées entre elles par un plateau (14).

7. Appareil de traitement selon l'une quelconque des revendications précédentes, caractérisé par le fait que lesdites secondes électrodes (66, 67) sont formées en saillie, sur un plateau (55) qui présente une multiplicité de canaux traversants (69) répartis autour desdites secondes électrodes en saillie en vue de l'écoulement des gaz au travers de ce plateau (55).

8. Appareil de traitement selon la revendication 7, caractérisé par le fait que la partie inférieure dudit plateau (55) est entourée à distance par un écran diffuseur (71) qui porte des écrans cylindriques (72) s'étendant à l'intérieur desdits canaux traversants (69) dudit plateau (55), à distance de leurs parois.

9. Appareil de traitement selon l'une des revendications 6 à 8, caractérisé par le fait que ledit plateau (14) portant lesdites secondes électrodes (15, 16) est muni d'au moins un canal intérieur dans lequel peut circuler un fluide de refroidissement.

10. Appareil de traitement selon l'une quelconque des revendications précédentes, caractérisé par le fait que des écrans isolés électriquement desdites secondes électrodes sont prévus autour de ces dernières dans leur partie s'étendant en dessous de leur surface de réception (15c, 16c) des plaquettes.

11. Appareil de traitement selon l'une quelconque des revendications précédentes, caractérisé par le fait que des écrans isolés électriquement desdites secondes électrodes sont prévus autour du plateau (14) portant ces secondes électrodes (15, 16).

12. Appareil de traitement selon l'une des revendications 10 et 11, caractérisé par le fait que lesdits écrans sont audit potentiel de référence.

13. Appareil de traitement selon l'une quelconque des revendications précédentes, caractérisé par le fait que ladite première électrode (46) est formée par un plateau s'étendant en face et à distance des surfaces de réception desdites secondes électrodes (15, 16), lesdits moyens d'amenée de gaz de réaction comprenant au moins une chambre (47) formée à l'intérieur de cette première électrode et des orifices de communication (49) entre cette chambre inférieure et l'intérieur de ladite enceinte de réaction qui sont situés en face du milieu de chacune desdites électrodes.

14. Appareil de traitement selon l'une quelconque des revendications précédentes, caractérisé par le fait que ledit plateau (38) présentant une multiplicité de passages traversants (40, 41) est amovible et est muni de moyens (42) pour maintenir respectivement, dans lesdits passages et à distance de leur paroi, des plaquettes, ce plateau (38) étant adapté pour être disposé ou monté dans ladite enceinte de réaction (2) de telle sorte que les plaquettes qu'il porte viennent en appui sur les surfaces de réception de plaquettes desdites secondes électrodes correspondantes.

15. Appareil de traitement selon la revendication 14, caractérisé par le fait que lesdits moyens de maintien des plaquettes dans lesdits passages traversants dudit plateau amovible (38) sont formés par des ergots (42) formant supports pour les plaquettes et maintenant ces plaquettes à distance des parois desdits passages traversants.

16. Appareil de traitement selon l'une des revendications 14 et 15, caractérisé par le fait que lesdits moyens pour porter et maintenir les plaquettes dans les passages traversants dudit plateau amovible (38) sont en un matériau isolant.

## Claims

1. Apparatus for plasma treatment of substrates in the form of wafers (45), comprising a reaction enclosure (2) exhibiting admission means (48) and evacuation means (50) for a reaction gas, at least one first electrode forming an anode (46), formed in the said enclosure and adapted to be connected to a reference potential and, placed within the said enclosure, a plurality of second electrodes forming cathodes electrically insulated from the said first electrode, the cathodes being adapted to be connected to a source of alternating electrical energy and exhibiting respectively a surface to receive at least one wafer situated on the same side as the said first electrode, in such a manner that a plasma may be formed between the said first electrode and the said second electrodes with a view to treating the wafers which the second electrodes carry, as well as at least one platform (38) exhibiting a plurality of through passages (40, 41) formed in such a manner as to correspond respectively to at least a part of the said second electrodes (15, 16) and adapted in order that the walls of these passages (40, 41) should extend respectively at the periphery and at a distance from the peripheral of the corresponding second electrodes (15, 16), characterized in that the spaces provided between the walls of the said through passages (40, 41) of the said platform (38) and the peripheral walls of the said second electrodes (15, 16) form flow passages for the reaction gas, the upper face of the said platform (38) extending substantially at the same level as the upper faces of the said second electrodes which it surrounds.

2. Treatment apparatus according to Claim 1, characterized in that the said platform (38) is electrically insulated from the said second electrodes (15, 16).

3. Treatment apparatus according to one of Claims 1 and 2, characterized in that the said platform (38) is at the said reference potential.

4. Treatment apparatus according to any one of Claims 1 to 3, characterized in that the said platform (38), together with the receiving surfaces of the said second electrodes (15, 16), divide the said reaction enclosure (2) into two chambers (11, 12) communicating through the said flow spacers.

5. Treatment apparatus according any one of the preceding claims, characterized in that the said cathodes (15, 16) are equipped with internal channels in which a cooling fluid can circulate.

6. Treatment apparatus according to any one of the preceding claims, characterized in that the ends of the said second electrodes (15, 16) opposite to their receiving surface (15c, 16c) are connected to one another by a platform (14).

7. Treatment apparatus according to any one of the preceding claims, characterized in that the said second electrodes (66, 67) are formed so as to project, on a platform (55) which exhibits a plurality of through channels (69) distributed around the said projecting second electrodes with a view to the flow of the gases through this platform (55).

8. Treatment apparatus according to Claim 7, characterized in that the lower part of the said platform (55) is surrounded, at a distance, by a diffusing screen (71) which carries cylindrical screens (72) extending within the said through channels (69) of the said platform (55), at a distance from their walls.

9. Treatment apparatus according to one of Claims 6 to 8, characterized in that the said platform (14) carrying the said second electrodes (15, 16) is equipped with at least one internal channel in which a cooling fluid can circulate.

10. Treatment apparatus according to any one of the preceding claims, characterized in that screens electrically insulated from the said second electrodes are provided around the latter in their part extending below their surface (15c, 16c) to receive the wafers.

11. Treatment apparatus according to any one of the preceding claims, characterized in that screens electrically insulated from the said second electrodes are provided around the platform (14) carrying these second electrodes (15, 16).

12. Treatment apparatus according to one of Claims 10 and 11, characterized in that the said screens are at the said reference potential.

13. Treatment apparatus according to any one of the preceding claims, characterized in that the said first electrode (46) is formed by a platform extending opposite and at a distance from the receiving surfaces of the said second electrodes (15, 16), the said means for admission of reaction gas comprising at least one chamber (47) formed within this first electrode and orifices for communication (49) between this lower chamber and the interior of the said reaction enclosure which are situated opposite the middle of each one of the said electrodes.

14. Treatment apparatus acccording to any one of the preceding claims, characterized in that the said platform (38) exhibiting a plurality of through passages (40, 41) is removable and is equipped with means (42) for maintaining respectively, within the said passages and at a distance from their wall, wafers, this platform (38) being adapted to be disposed or mounted within the said reaction enclosure (2) in such a manner that the wafers which it carries are supported on the wafer-receiving surfaces of the said corresponding second electrodes.

15. Treatment apparatus according to Claim 14, characterized in that the said means for maintaining the wafers within the said through passages of the said removable platform (38) are formed by lugs (42) forming supports for the wafers and maintaining these wafers at a distance from the walls of the said through passages.

16. Treatment apparatus according to one of Claims 14 and 15, characterized in that the said means for carrying and maintaining the wafers within the through passages of the said removable platform (38) are of an insulating material.

**Patentansprüche**

1. Gerät zur Plasmabearbeitung von Substraten (45) in Form von Plättchen, mit einem Reaktionsraum (2) mit Mitteln (48) zur Zuführung und Mitteln (50) zur Evakuierung eines Reaktionsgases mit wenigstens einer ersten, eine Anode (46) bildenden Elektrode, die in dem Reaktionsraum angeordnet und mit einem Referenzpotential verbindbar ist, mit mehreren in dem Reaktionsraum angeordneten zweiten Elektroden, die Kathoden bilden und gegenüber der ersten Elektrode elektrisch isoliert und mit einer Wechselspannungsquelle verbindbar sind, wobei die zweiten Elektroden jeweils Aufnahmeflächen für wenigstens ein auf Seiten der ersten Elektrode liegendes Plättchen aufweisen, derart daß zwischen der ersten Elektrode und den zweiten Elektroden ein Plasma zur Bearbeitung der von den zweiten Elektroden getragenen Plättchen gebildet werden kann, sowie mit wenigstens einer Platte (38) mit mehreren Durchgängen (40, 41), die so angeordnet sind, daß die jeweils mit wenigstens einem Teil der zweiten Elektroden (15, 16) korrespondieren und so angepaßt sind, daß die Wandungen dieser Durchgänge (40, 41) sich jeweils zur Peripherie und im Abstand von den umlaufenden Wandungen der korrespondierenden zweiten Elektroden (15, 16) erstrecken, dadurch gekennzeichnet, daß die zwischen den Wandungen der Durchgänge (40, 41) der Platte (38) und den peripheren Wandungen der zweiten Elektroden (15, 16) angebrachten Zwischenräume Strömungsdurchgänge für das Reaktionsgas bilden, und daß die Oberseite der Platte (38) zumindest annähernd auf demselben Niveau liegt wie die Oberseiten der zweiten Elektroden, die von ihr umschlossen werden.

2. Plasmabearbeitungsgerät nach Anspruch 1, dadurch gekennzeichnet, daß die Platte (38) gegenüber den zweiten Elektroden (15, 16) elektrisch isoliert ist.

3. Plasmabearbeitungsgerät nach einem der Ansprüche 1 und 2, dadurch gekennzeichnet, daß die Platte (38) sich auf dem genannten Referenzpotential befindet.

4. Plasmabearbeitungsgerät nach einem der Ansprüche 1 bis 3, dadurch gekennzeichnet, daß die Platte (38) mit den Aufnahmeflächen der zweiten Elektroden (15, 16) den Reaktionsraum in zwei Kammern (11, 12) unterteilt, die über die Strömungsdurchgänge miteinander in Verbindung stehen.

5. Plasmabearbeitungsgerät nach einem der vorgehenden Ansprüche, dadurch gekennzeichnet, daß innerhalb der Kathoden (15, 16) Kanäle gebildet sind, in denen eine Kühlflüssigkeit zirkulieren kann.

6. Plasmabearbeitungsgerät nach einem der vorgehenden Ansprüche, dadurch gekennzeichnet, daß die der Aufnahmefläche (15c, 16c) entgegengesetzten Endbereiche der zweiten Elektroden (15, 16) durch eine Platte (14) miteinander verbunden sind.

7. Plasmabearbeitungsgerät nach einem der vorhergehenden Ansprüche, dadurch gekennzeichnet, daß die zweiten Elektroden (66, 67) als Vorsprünge auf einer Platte (55) ausgebildet sind, die mehrere durchgehende Kanäle (69) aufweist, die um die hervorstehenden zweiten Elektroden verteilt sind und eine Gasströmung durch die Platte (55) ermöglichen.

8. Plasmabearbeitungsgerät nach Anspruch 7, dadurch gekennzeichnet, daß der untere Teil der Platte (55) im Abstand von einem Diffusorschirm (41) umgeben ist, der zylindrische Abschirmungen (72) trägt, die ins Innere der die Platte (55) durchdringenden Kanäle (69) ragen, wobei sie von den Wandungen dieser Kanäle Abstand halten.

9. Plasmabearbeitungsgerät nach einem der Ansprüche 6 bis 8, dadurch gekennzeichnet, daß die die zweiten Elektroden (15, 16) tragende Platte (14) wenigstens einen inneren Kanal aufweist, in dem eine Kühlflüssigkeit zirkulieren kann.

10. Plasmabearbeitungsgerät nach einem der vorhergehenden Ansprüche, dadurch gekennzeichnet, daß Abschirmungen vorgesehen sind, die gegenüber den zweiten Elektroden elektrisch isoliert sind und diese in ihrem unter der Aufnahmefläche (15c, 16c) der Plättchen liegenden Teil umgeben.

11. Plasmabearbeitungsgerät nach einem der vorhergehenden Ansprüche, dadurch gekennzeichnet, daß gegenüber den zweiten Elektroden isolierte Abschirmungen vorgesehen sind, die die zweiten Elektroden (15, 16) tragende Platte (14) umgeben.

12. Plasmabearbeitungsgerät nach einem der Ansprüche 10 und 11, dadurch gekennzeichnet, daß die Abschirmungen auf dem genannten Referenzpotential liegen.

13. Plasmabearbeitungsgerät nach einem der vorhergehenden Ansprüche, dadurch gekennzeichnet, daß die erste Elektrode (46) von einer Platte gebildet ist, die den Aufnahmeflächen der zweiten Elektroden mit Abstand gegenüberliegt, daß die genannten Mittel zur Zuführung von Reaktionsgas wenigstens eine im Innern der ersten Elektrode gebildete Kammer (47) sowie Verbindungsöffnungen (49) zwischen dieser Kammer und dem Innenraum des Reaktionsraums umfassen, die der Mitte jeder zweiten Elektrode gegenüberliegen.

14. Plasmabearbeitungsgerät nach einem der vorhergehenden Ansprüche, dadurch gekennzeichnet, daß die mehrere Durchgänge (40, 41) aufweisende Platte (38) entfernbar ist und Mittel (42) zur Halterung von Plättchen in den genannten Durchgängen und im Abstand von deren Wandung aufweist und daß die Platte (38) in dem Reaktionsraum (2) derart angeordnet und montiert werden kann, daß die von ihr getragenen Plättchen sich auf den Plättchen-Aufnahmeflächen der entsprechenden zweiten Elektroden abstützen.

15. Plasmabearbeitungsgerät nach Anspruch 14, dadurch gekennzeichnet, daß die Mittel zur Halterung der Plättchen in den Durchgängen der entfernbaren Platte (38) aus Vorsprüngen (42) bestehen, die Träger für die Plättchen bilden und diese im Abstand von den Wandungen der genannten Durchgänge halten.

16. Plasmabearbeitungsgerät nach einem der Ansprüche 14 und 15, dadurch gekennzeichnet, daß die Mittel zum Tragen und Halten der Plättchen in den Durchgängen der entfernbaren Platte (38) aus Isoliermaterial bestehen.

FIG.1

## FIG.2

# FIG.3

0 148 898

FIG.4

FIG.5

## FIG.6